# EUROPEAN PATENT SPECIFICATION

(11) **EP 0 521 678 B1**
(45) Date of publication and mention of the grant of the patent: **03.09.1997**
(21) Application number: 92305958.8
(22) Date of filing: 29.06.1992
(51) Int. Cl.: H01L 21/3205, H01L 21/3215

(54) **I'ionsmplanted polysilicon resistor using an oxide screen**
Implantierter Polysilizium-Widerstand mit Oxidschirm
Résistance en polysilicium comportant d'ions implantés et utilisant un écran d'oxyde

(30) Priority: 01.07.1991 US 723585
(43) Date of publication of application: 07.01.1993
(73) Proprietor: SGS-THOMSON MICROELECTRONICS, INC., Carrollton Texas 75006 (US)
(72) Inventor: Miller, Robert O., The Colony, Texas 75056 (US); Chen, Fusen E., Dallas, Texas 75287 (US)
(74) Representative: Palmer, Roger

(56) References cited:
- EP-A- 0 145 926
- GB-A- 2 110 470
- GB-A- 2 207 809
- US-A- 4 828 629
- IBM TECHNICAL DISCLOSURE BULLETIN, vol. 24, no. 1A, June 1981, New York US, pp. 74-75; J.M. LEAS et al.: 'Polysilicon Resistor Process'

## Description

This invention relates to improvements in semiconductor processes, and more particularly to improvements in methods for fabricating resistors in polysilicon layers.

It is desirable, in the manufacture of resistor-load SRAMs for example, to produce very high-valued polycrystalline silicon (polysilicon) resistors, for instance, with resistances as high as 1 to 10 teraohms (one teraohm ≡ 1TΩ ≡ 10¹²Ω). It is usually preferable for the resistor bodies, or "channels", to be lightly-doped with boron in order to enhance the reverse diode formed by the junction of each channel area with its heavily-doped contact area.

Typically, the polysilicon layer in which the resistor is formed is between 500Å and 1000Å thick, to achieve high resistance. It is desirable, in the channel doping, to implant the boron so that the peak of the (approximately Gaussian) profile lies at or near the center of the polysilicon film in which the resistor is formed. This guarantees that, after nominal annealing, the resulting profile is most nearly uniform through the film, and is repeatable in concentration. It also prevents the existence of a significant amount of the distribution running deep into the underlying layers.

One problem that exists is that commercial ion implantation equipment is not easily operated at beam energies below 25 keV. At such low beam energies, the projected range for boron is about 825Å. On the other hand, it is preferable to operate with a minimum of 30keV beam current, where the projected range would be about 1000Å. However, in both instances, the peak of the implanted boron distribution is well beyond the center of the film thickness.

Another problem is that when boron is directly implanted into the poly film., it is done so with the resistor channel exposed. However, ion implantation usually entails relatively high particle contamination of wafers, and high-value resistors are extremely vulnerable to such contamination. Even small levels of contamination can dramatically change the resistivity of polysilicon, especially when the polysilicon is lightly doped, and, as a consequence, such direct implantation is not an ideal solution.

A prior art document, GB-A-2110470 discloses a polycrystalline semiconductor resistor in which impurity ions are implanted to have a concentration profile which is higher in the interior region of the resistor than near the boundaries of the resistor. This is said to reduce 1/F noise.

In the light of the above, it is, therefore, an object of the invention to provide an improved method for fabricating a resistor in a polysilicon layer in which prior to annealing the doping profile is approximately Gaussian, with the highest concentration of dopant in the center of the polysilicon layer. After annealing of this structure, the dopant concentration is substantially uniform throughout the polysilicon layer.

It is another object of the invention to provide a method of the type described, which is not as vulnerable to contamination as previous techniques.

It is still another object of the invention to provide a method of the type described in which the doping concentration distribution is more readily repeatable.

It is yet another object of the invention to provide a method of the type described, which can use standard, readily available semiconductor fabrication or ion implantation equipment.

It is still a further object of the invention to provide a method of the type described, which adds no extra steps or complexity to standard integrated circuit fabrications processes.

These and other objects, features and advantages of the invention will become apparent to those skilled in the art from the following detailed description, when read in conjunction with the accompanying drawings and appended claims.

According to a first aspect of the present invention there is provided a method for fabricating a polysilicon resistor structure, comprising forming a layer of polysilicon of a first predetermined thickness; forming a layer of undoped oxide of a second predetermined thickness over the layer of polysilicon; implanting a dopant (Bo) through said layer of undoped oxide into said layer of polysilicon to form the resistor structure in said layer of polysilicon whereby said second predetermined thickness is selected such that a given implantation energy produces a peak concentration of said dopant at a depth of approximately one-half of the thickness of said layer of polysilicon; and annealing said structure whereby said dopant concentration is substantially uniform throughout said thickness.

In the embodiment a method for fabricating resistors in a polysilicon film or layer is presented. The method includes the step of providing a screen of undoped deposited oxide over the polysilicon film prior to the dopant implantation. The oxide then enables dopant implantation energies to be chosen within the recommended operating range of commercially available equipment and ideal processing parameters so that the distribution peak is near the center of the polysilicon film, and shields the polysilicon surface from contamination.

More particularly, a method is presented for fabricating a polysilicon resistor structure in which a layer of polysilicon is formed over an insulation layer on a substrate. The insulation layer may have windows through which the polysilicon may extend to contact the substrate. Selected regions of. the polysilicon layer are implanted to form conductive regions,. for interconnections, buses, and the like, and the polysilicon layer is patterned and selectively removed to create a desired resistor network pattern. A layer of undoped oxide is formed overall to fully encapsulate the top and sides of the polysilicon network pattern. The thickness of the undoped oxide is selected to enable a dopant implantation energy to be determined that will result in dopant being implanted through the undoped oxide, as a screen, with a peak concentration of dopant located at a central depth in the layer of polysilicon. Thereafter, a layer of BPSG is formed over the oxide and reflowed to produce a planarized structure.

The invention is illustrated in the accompanying drawing, in which:

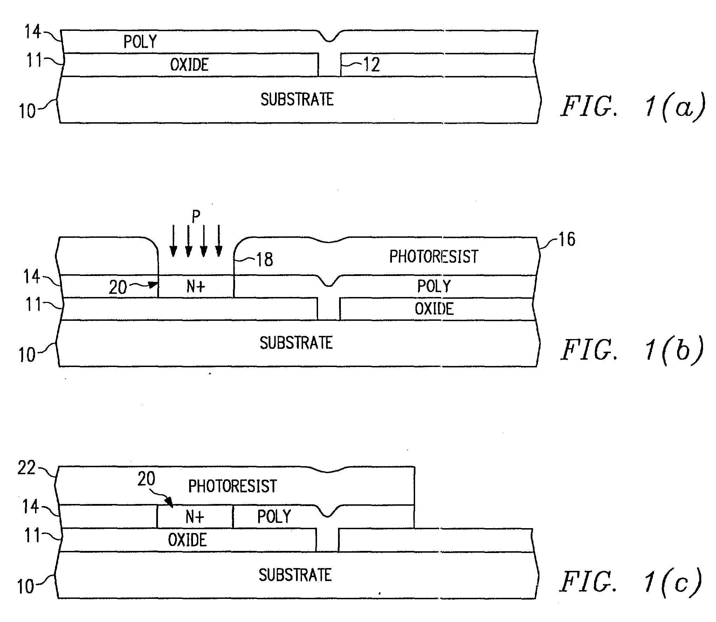

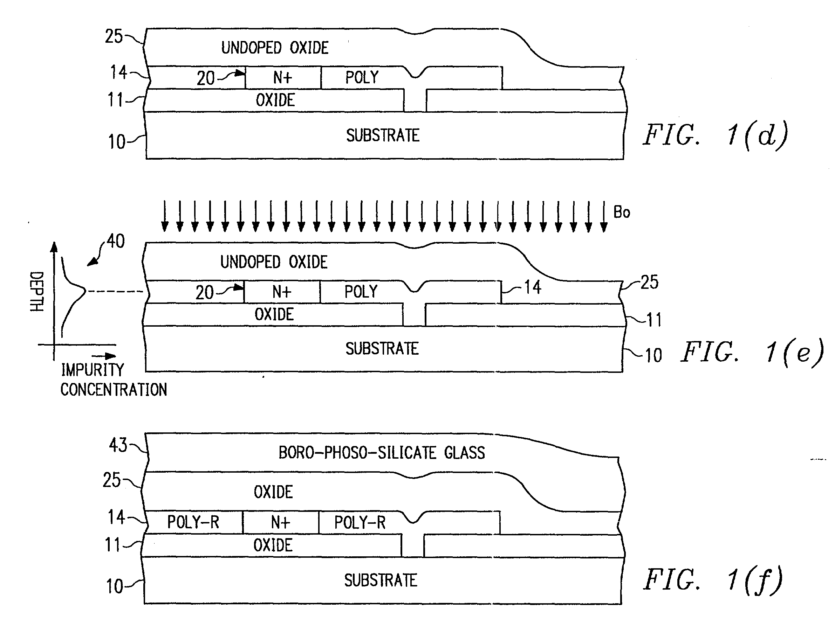

Figures 1(a) - 1(f) are cross-sectional views of an integrated circuit device in various stages of its manufacture, in accordance with the method of a preferred embodiment of the invention.

In the various figures of the drawing, the sizes and dimensions of the parts has been exaggerated or distorted for clarity of illustration and ease of description. Also, in the various figures, like reference numerals are used to denote like or similar parts.

The steps for fabricating a resistor in a polysilicon layer, in accordance with a preferred embodiment of the invention are illustrated in Figures 1(a) - 1(f), cross-sectional views of an integrated circuit device in various stages of its manufacture. Such resistors can be used, for example, in many integrated circuit devices, one excellent example of use being 1 - 4 megabit, 4T2R SRAM devices. It should be noted that the process steps and structures herein described do not necessarily form a complete process flow for manufacturing integrated circuits. It is anticipated that the present invention may be practiced in conjunction with integrated circuit fabrication techniques currently used in the art, and only so much of the commonly practiced process steps are included as are necessary for an understanding of the present invention. Moreover, although the invention is illustrated with various parts and layers of certain conductivity types and of certain dopants of specified doping concentrations, those skilled in the art will recognize that other, perhaps even opposite, conductivity types, and other dopants and different doping concentrations might be used to equal advantage.

Thus, in accordance with one embodiment of the invention, as shown in Figure 1(a), a substrate 10 is provided, on which a layer of insulation, such as oxide layer 11 is formed, for example, by known techniques, such as by thermal oxidation, or other known method. The substrate 10 can be silicon or polysilicon to which, in the embodiment illustrated, contact is to be made, for example. The oxide layer 11 is masked and etched to form a window or via 12 through which contact can be made to the underlying substrate 10. A layer 14 of polysilicon, in which a resistor will be subsequently formed, in accordance with a preferred embodiment of the invention, will be formed. The polysilicon layer 14 can be formed, for instance by CVD or other process, over the oxide layer 11 to extend into the window 12 to contact the underlying substrate 10. The thickness of the polysilicon layer 14 can be the same as that presently employed, for example, in the range of between about 500Å and 1000Å.

As shown in Figure 1(b), a layer of photoresist 16 is formed over the polysilicon film 14. The photoresist layer 16 is masked, exposed, and selectively removed, in accordance with known techniques, to form a window 18 overlying the portions 20 of the polysilicon layer 14 that will be implanted to form conductive regions, such as for example interconnects, buses, wiring, a V_{cc} rail, and so on. Thus, for example, phosphorus or arsenic can be implanted to produce highly doped N+ regions in the exposed portions 20 of the polysilicon layer 14. The photoresist layer 16 is then stripped.

Next, as shown in Figure 1(c), a new layer 22 of photoresist is formed over the structure, including the highly doped region 20. The photoresist layer 22 is then masked, exposed, and etched to the level of the oxide layer 11 to remove the exposed photoresist material and the portions of the polysilicon layer 14 lying beneath the exposed photoresist regions to create from the remaining portions of the polysilicon layer 14 the desired resistor network. In the resistor network, typically the body of the resistors that will ultimately be formed will be on the order of about 2µm to 4µm long by about 1µm wide. The photoresist layer 22 is then stripped.

Following the removal of the unwanted regions of the polysilicon layer 14, as shown in Figure 1(d), a layer 25 of undoped oxide is deposited overall, for example by a known TEOS reduction process. The thickness of the layer 25 can be, for example, in the range of between about 1200Å to 1500Å, or other suitable thickness to accomplish the desired distribution of dopant implanted to form the resistor in the underlying polysilicon layer 14. That is, the thickness of the oxide layer 25 is selected to enable the dopant implantation energies to be chosen so that the dopant concentration distribution peak is near the center of the polysilicon film 14. The thickness of the oxide layer 25 can be determined by known techniques, such as by LSS computer modeling techniques or by other known process modeling simulation techniques to achieve the desired dopant concentration distribution. The oxide layer 25 also serves to shield the surface of the polysilicon layer 14 from contamination.

Moreover, since the oxide layer 25 is deposited after the resistor pattern is etched, the layer 14 of polysilicon is completely encapsulated by the oxide. Furthermore, since all other operations pertaining to resistor formation are complete at that point, the screen provided by the oxide layer 25 can remain permanently, thus avoiding the detrimental effects on the resistors that might attend if the oxide layer 25 were to be removed. The screen provided by the oxide layer 25, in fact, can comprise the undoped oxide underlayer that is needed for subsequent BPSG planarizing films, with the dopant implantation energy adjusted to accommodate the thickness requirements of the sub-BPSG oxide. Preferably, the oxide layer 25 is deposited after the resistor network is formed, since otherwise, resistor degradation might result.

As shown in Figure 1(e), a dopant, such as boron, is implanted through the oxide layer 25 into the polysilicon layer 14. In accordance with the invention, the dopant is implanted so that the peak concentration of dopant is maximum at approximately the center of the polysilicon layer 14, as shown by the graph 40 of impurity concentration vs. depth adjacent the drawing in Figure 1(e). The depth scale of the graph 40 is approximately the same as the stylized cross-section of the portion of the integrated circuit shown, to emphasize the Gaussian distribution of dopant from the surface of the device in the direction of the substrate. It has been found, for example, that with a layer of undoped oxide having a thickness of between about 1100Å and 1500Å, for example about 1220Å, and with an implantation energy of between about 40keV and 60keV, for example, between about 45keV and 55keV, boron can be implanted, for example, in doses of between about (1 X 10¹² cm⁻² to 1 X 10¹³ cm⁻²) to produce the doping profile generally shown by the graph 40.

As mentioned, when the boron doped region is formed with a resistor body dimensions of between about 2 to 4µm long by 1µm wide, in the polysilicon films of thickness between about 500Å to 1000Å thick, it has been found that a final resistance value of between about 0.1 to 10.0 TΩ can be achieved. Also, as mentioned, other dopants, such as arsenic, antimony, phosphorus, or the like can be used in place of the boron implant dopant described.

To complete the device, next, as shown in Figure 1(f), a layer of boro-phoso-silicate glass (BPSG) 43 can be formed, and reflowed over the surface of the structure. After the glass layer 43 is reflowed, it should be noted that since the flattest part of the approximately Gaussian profile of the implanted resistor dopant was at the peak in about the center of the depth of the polysilicon film 14 prior to reflowing the BPSG, a high-level of repeatability to the average concentration is achievable. Moreover, because of the centrally located flat part of the implant, and because of the small amount of implanted dopant extending beyond the bottom of the polysilicon film 14, after subsequent high temperature annealing, a nearly constant concentration of dopant is created from the top to the bottom of the polysilicon layer 14.

## Claims

1. A method for fabricating a polysilicon resistor structure, comprising:
forming a layer of polysilicon (14) of a first predetermined thickness;
forming a layer of undoped oxide (25) of a second predetermined thickness over the layer of polysilicon (14);
implanting a dopant (Bo) through said layer of undoped oxide (25) into said layer of polysilicon (14) to form the resistor structure in said layer of polysilicon whereby said second predetermined thickness is selected such that a given implantation energy produces a peak concentration of said dopant at a depth of approximately one-half of the thickness of said layer of polysilicon (14); and
annealing said structure whereby said dopant concentration is substantially uniform throughout said thickness.

2. The method of claim 1 wherein said second thickness is between about 1200A to about 1500A and said first thickness is between about 500A to about 1000A.

3. The method of claim 1 or 2 further comprising the step of producing highly doped regions (20) at selected locations in said polysilicon layer (14).

4. The method of claim 3 wherein said step of producing highly doped regions (20) comprises implanting an n-type impurity (P) into said selected locations of said layer of polysilicon (14).

5. The method of claim 1 or 2 further comprising patterning said layer of polysilicon (14) prior to said step of forming said layer of undoped oxide (25) to form a desired resistor network pattern, whereby said undoped oxide (25) is formed to surround the top and sides of said layer of polysilicon (14).

6. A method for fabricating a polysilicon resistor structure, as claimed in claim 1 comprising:
providing a substrate (10);
forming a layer of insulation (11) on said substrate (10);
forming a window (12) in said layer of insulation (11) extending to said substrate (10);
forming said layer of polysilicon (14) on said layer of insulation (11) and extending into said window (12) to contact said substrate (10);
forming a first mask (16) over said layer of polysilicon (14) to provide a window (18) to expose implantion regions (20) of said layer of polysilicon (14);
implanting said exposed implantation regions (20) to form conductive regions in said layer of polysilicon (14);
stripping said first mask (16);
forming a second mask (22) over said polysilicon layer (14);
removing, using said second mask (22), portions of said polysilicon layer (14) to create a desired resistor network pattern;
removing said second mask (22);
forming said layer of undoped oxide (25) overall having a second predetermined thickness;
implanting said dopant (Bo);
providing a layer of boro-phoso-silicate glass (43) overall;
and heating said layer of boro-phoso-silicate glass (43) to cause said layer of boro-phoso-silicate glass (43) to reflow and planarize; and
annealing said structure whereby said dopant concentration is substantially uniform throughout said thickness.

7. The method of claim 6, wherein said step of forming a layer of insulation (11) comprises forming a layer of oxide.

8. The method of claim 7 wherein said step of forming a layer of oxide comprises thermally growing oxide on said substrate.

9. The method of claim 6 wherein said step of forming a layer of polysilicon (14) comprises depositing said polysilicon by a CVD process.

10. The method of claim 6 wherein said window (18) of said masking layer (16) defines routes for conductive paths in said polysilicon layer (14).

11. The method of claim 6 further comprising producing highly doped regions (20) in said polysilicon layer (14) by selectively implanting an n-type impurity (P) into said polysilicon layer (14).

12. The method of claim 11 comprising the step of selecting said n-type impurity (P) from the group consisting of phosphorus and arsenic.

13. The method of claim 5 or 6, wherein said step of forming said desired resistor network pattern comprises the steps of forming said polysilicon layer (14) to have resistor body patterns of between about 2 to 4 µm long and about 1 µm wide.

14. The method of claim 1 or 6 wherein said step of forming said layer of undoped oxide (25) overall is accomplished by a TEOS reduction process.

15. The method of claim 6 wherein said step of forming said layer of undoped oxide (25) overall is accomplished by forming an undoped oxide layer (25) of thickness of between about 1200A to 1500A.

16. The method of claim 15 further comprising completely encapsulating said polysilicon layer (14) with said layer of undoped oxide (25).

17. The method of claim 1 or 6 further comprising the step of allowing said layer of undoped oxide (25) to remain permanently on said polysilicon layer (14).

18. The method of claim 17 further comprising the step of permitting said layer of undoped oxide (25) to serve as a sub-BPSG oxide.

19. The method of claim 1 or 6 wherein said step of implanting a dopant (Bo) through said layer of undoped oxide (25) comprises implanting boron ions.

20. The method of claim 19 wherein said step of implanting boron comprises implanting boron with an implantation energy of between about 40keV and 60keV.

21. The method of claim 1 or 6 wherein said step of implanting a dopant (Bo) comprises implanting dopant selected from the group consisting of boron, antimony, and arsenic.

## Patentansprüche

1. Verfahren zur Herstellung eines Widerstandsaufbaus aus Polysilizium, das aufweist:
eine Schicht aus Polysilizium (14) einer ersten vorbestimmten Dicke wird ausgebildet;
eine Schicht aus undotiertem Oxid (25) einer zweiten vorbestimmten Dicke wird über der Schicht aus Polysilizium (14) ausgebildet;
ein Dotiermittel (Bo) wird durch die Schicht aus undotiertem Oxid (25) in die Schicht aus Polysilizium (14) implantiert, um den Widerstandsaufbau in der Schicht aus Polysilizium auszubilden, wodurch die zweite vorbestimmte Dicke so ausgewählt wird, daß eine gegebene Implantationsenergie eine Spitzenkonzentration des Dotiermittels bei einer Tiefe von näherungsweise einer Hälfte der Dicke der Schicht aus Polysilizium (14) erzeugt; und
der Aufbau wird erhitzt bzw. geglüht, wodurch die Dotiermittelkonzentration im wesentlichen über die gesamte Dicke gleichmäßig bzw. einheitlich ist.

2. Verfahren nach Anspruch 1, wobei die zweite Dicke zwischen ungefähr 1200 Å bis ungefähr 1500 Å ist und die erste Dicke zwischen ungefähr 500 Å bis ungefähr 1000 Å ist.

3. Verfahren nach Anspruch 1 oder 2, das ferner den Schritt aufweist, hochdo tierte Bereiche (20) an ausgewählten Plätzen in der Polysiliziumschicht (14) zu erzeugen.

4. Verfahren nach Anspruch 3, bei dem der Schritt zum Erzeugen hochdotierter Bereiche (20) das Implantieren einer n-Typ-Verunreinigung (P) in die ausgewählten Plätze der Schicht aus Polysilizium (14) aufweist.

5. Verfahren nach Anspruch 1 oder 2, das ferner aufweist, daß die Schicht aus Polysilizium (14) vor dem Schritt zum Ausbilden der Schicht aus undotiertem Oxid (25) strukturiert bzw. mit einem Muster versehen wird, um ein gewünschtes Widerstandsnetzwerkmuster bzw. Widerstandsnetzwerkstruktur zu bilden, wodurch das undotierte Oxid (25) ausgebildet wird, um den oberen Abschnitt bzw. Kopf und die Seiten der Schicht aus Polysilizium (14) zu umgeben.

6. Verfahren zur Herstellung eines Widerstandsaufbaus aus Polysilizium nach Anspruch 1, das aufweist:
ein Substrat (10) wird bereitgestellt;
eine Isolationsschicht (11) wird auf dem Substrat (10) ausgebildet;
ein Fenster (12) wird in der Isolationsschicht (11) ausgebildet, das sich zu dem Substrat (10) erstreckt;
die Schicht aus Polysilizium (14) wird auf der Isolationsschicht (11) ausgebildet und erstreckt sich in das Fenster (12), um das Substrat (10) anzuschließen bzw. zu kontaktieren;
eine erste Maske (16) wird über der Schicht aus Polysilizium (14) ausgebildet, um ein Fenster (18) bereitzustellen, um die implantierten Bereiche (20) der Schicht aus Polysilizium (14) freizulegen;
die freigelegten implantierten Bereiche (20) werden implantiert, um leitende Bereiche in der Schicht aus Polysilizium (14) zu bilden;
die erste Maske (16) wird entfernt bzw. gestrippt;
eine zweite Maske (22) wird über der Polysiliziumschicht (14) ausgebildet;
Abschnitte der Polysiliziumschicht (14) werden unter Verwendung der zweiten Maske (22) entfernt, um ein gewünschtes Widerstandsnetzwerkmuster bzw. eine Widerstandsnetzwerkstruktur zu erzeugen;
die zweite Maske (22) wird entfernt;
die Schicht aus undotiertem Oxid (25) wird über allem ausgebildet, die eine zweite vorbestimmte Dicke hat;
das Dotiermittel (Bo) wird implantiert;
eine Schicht aus Borphosphorsilikatglas (43) wird über allem bereitgestellt;
die Schicht aus Borphosphorsilikatglas (43) wird erhitzt bzw. geheizt, um die Schicht aus Borphosphorsilikatglas (43) dazu zu veranlassen, wieder flüssig und eingeebnet bzw. planarisiert zu werden; und
der Aufbau wird geglüht bzw. ausgeheizt, wodurch die Dotiermittelkonzentration über die Dicke im wesentlichen gleichmäßig bzw. einheitlich ist.

7. Verfahren nach Anspruch 6, bei dem der Schritt zum Bilden einer Isolierschicht (11) aufweist, daß eine Oxidschicht ausgebildet wird.

8. Verfahren nach Anspruch 7, bei dem der Schritt zum Ausbilden einer Oxidschicht ein thermisches Aufwachsen von Oxid auf dem Substrat aufweist.

9. Verfahren nach Anspruch 6, bei dem der Schritt zum Ausbilden einer Schicht aus Polysilizium (14) das Abscheiden bzw. Ablagern des Polysiliziums durch einen CVD-Prozeß aufweist.

10. Verfahren nach Anspruch 6, bei dem das Fenster (18) der Maskierungsschicht (16) Wege für leitende Pfade in der Polysiliziumschicht (14) festlegt.

11. Verfahren nach Anspruch 6, das ferner die Erzeugung stark- bzw. hochdo tierter Bereiche (20) in der Polysiliziumschicht (14) durch wahlweises Implantieren einer n-Typ-Verunreinigung (P) in die Polysiliziumschicht (14) aufweist.

12. Verfahren nach Anspruch 11, das ferner den Schritt aufweist, die Verunreinigung (P) vom n-Typ aus der Gruppe auszuwählen, die aus Phosphor und Arsen besteht.

13. Verfahren nach Anspruch 5 oder 6, bei dem der Schritt zum Ausbilden des gewünschten Widerstandsnetzwerkmusters bzw. der gewünschten Widerstandsnetzwerkstruktur die Schritte aufweist, die Polysiliziumschicht (14) auszubilden, um Widerstandskörperstrukturen bzw. -muster von zwischen ungefähr 2 bis 4 µm Länge und ungefähr 1 µm Breite aufzuweisen.

14. Verfahren nach Anspruch 1 oder 6, bei dem der Schritt zum Ausbilden der Schicht aus undotiertem Oxid (25) über allem durch ein TEOS-Reduktionsverfahren realisiert wird.

15. Verfahren nach Anspruch 6, bei dem der Schritt zum Ausbilden der Schicht aus undotiertem Oxid (25) über allem durch Ausbilden einer undotierten Oxidschicht (25) einer Dicke von zwischen ungefähr 1200 Å bis 1500 Å realisiert wird.

16. Verfahren nach Anspruch 15, das ferner die vollständige Verkapselung der Polysiliziumschicht (14) mit der Schicht aus undotiertem Oxid (25) aufweist.

17. Verfahren nach Anspruch 1 oder 6, das ferner den Schritt aufweist, es der Schicht aus undotiertem Oxid (25) zu ermöglichen, dauerhaft auf der Polysiliziumschicht (14) zu verbleiben.

18. Verfahren nach Anspruch 17, das ferner den Schritt aufweist, es der Schicht aus undotiertem Oxid (25) zu ermöglichen, als ein Sub-BPSG-Oxid zu dienen.

19. Verfahren nach Anspruch 1 oder 6, bei dem der Schritt zum Implantieren eines Dotiermittels (Bo) durch die Schicht aus undotiertem Oxid (25) aufweist, daß Borionen implantiert werden.

20. Verfahren nach Anspruch 19, bei dem der Schritt des Implantierens von Bor aufweist, daß Bor mit einer Implantationsenergie von zwischen ungefähr 40 keV und 60 keV implantiert wird.

21. Verfahren nach Anspruch 1 oder 6, bei dem der Schritt des Implantierens eines Dotiermittels (Bo) aufweist, daß ein Dotiermittel implantiert wird, das aus der Gruppe ausgewählt ist, die aus Bor, Antimon und Arsen besteht.

## Revendications

1. Procédé de fabrication d'une structure de résistance en polysilicum, comprenant :
- la formation d'une couche en polysilicum (14) d'une première épaisseur prédéterminée ;
- la formation d'une couche d'oxyde non dopé (25) d'une seconde épaisseur prédéterminée sur la couche en polysilicum (14) ;
- l'implantation d'un agent de dopage (Bo) à travers ladite couche d'oxyde non dopé (25) dans ladite couche en polysilicum (14) pour former la structure de résistance dans ladite couche en polysilicum de sorte que ladite seconde épaisseur prédéterminée est sélectionnée de façon qu'une énergie d'implantation donnée produise une concentration maximale dudit agent de dopage à une profondeur d'environ la moitié de l'épaisseur de ladite couche en polysilicum (14) ; et
- le recuit de ladite structure de sorte que ladite concentration en agent de dopage soit sensiblement uniforme tout au long de ladite épaisseur.

2. Procédé selon la revendication 1, dans lequel ladite seconde épaisseur est comprise entre environ 1.200 Å et environ 1.500 Å et ladite première épaisseur est comprise entre environ 500 Å et environ 1.000 Å.

3. Procédé selon la revendication 1 ou 2, comprenant de plus l'étape de production de zones fortement dopées (20) à des emplacements sélectionnés dans ladite couche en polysilicum (14).

4. Procédé selon la revendication 3, dans lequel ladite étape de production de zones fortement dopées (20) comprend l'implantation d'une impureté (P) du type N dans lesdits emplacements sélectionnés de ladite couche en polysilicum (14).

5. Procédé selon la revendication 1 ou 2, comprenant de plus la formation de motifs de ladite couche en polysilicum (14) avant ladite étape de formation de ladite couche d'oxyde non dopé (25) pour former un motif de réseau de résistances, de sorte que ledit oxyde non dopé (25) est formé pour entourer le dessus et les côtés de ladite couche en polysilicum (14).

6. Procédé de fabrication d'une structure de résistance en polysilicum, selon la revendication 1, comprenant :
- la présence d'un substrat (10) ;
- la formation d'une couche d'isolant (11) sur ledit substrat (10) ;
- la formation d'une fenêtre (12) dans ladite couche d'isolant (11) s'étendant jusqu'audit substrat (10) ;
- la formation de ladite couche en polysilicum (14) sur ladite couche d'isolant (11) et s'étendant dans ladite fenêtre (12) pour venir en contact avec ledit substrat (10) ;
- la formation d'un premier masque (16) sur ladite couche en polysilicum (14) pour réaliser une fenêtre (18) pour exposer les zones d'implantation (20) de ladite couche en polysilicum (14) ;
- l'implantation desdites zones d'implantation exposées (20) pour former des zones conductrices dans ladite couche en polysilicum (14) ;
- l'élimination dudit premier masque (16) ;
- la formation d'un second masque (22) sur ladite couche en polysilicum (14) ;
- l'enlèvement, en utilisant ledit second masque (22), de parties de ladite couche en polysilicum (14) pour créer un motif de réseau de résistances souhaité ;
- l'enlèvement dudit second masque (22) ;
- la formation de ladite couche d'oxyde non dopé (25) sur la totalité en ayant une seconde épaisseur prédéterminée ;
- l'implantation dudit agent de dopage (Bo) ;
la présence d'une couche de verre de boro-phoso-silicate (43) sur la totalité ;
- et le chauffage de ladite couche de verre de boro-phoso-silicate (43) pour obliger ladite couche de verre de boro-phoso-silicate (43) à fondre et à devenir plane ; et
- le recuit de ladite structure de sorte que ladite concentration en agent de dopage soit sensiblement uniforme tout au long de ladite épaisseur.

7. Procédé selon la revendication 6, dans lequel ladite étape de formation d'une couche d'isolant (11) comprend la formation d'une couche d'oxyde.

8. Procédé selon la revendication 7, dans lequel ladite étape de formation d'une couche d'oxyde comprend la croissance thermique de l'oxyde sur ledit substrat.

9. Procédé selon la revendication 6, dans lequel ladite étape de formation d'une couche en polysilicum (14) comprend le dépôt dudit polysilicium par un processus CVD.

10. Procédé selon la revendication 6, dans lequel ladite fenêtre (18) de ladite couche de masquage (16) définit des trajets pour des chemins conducteurs dans ladite couche en polysilicum (14).

11. Procédé selon la revendication 6, comprenant de plus la production de zones hautement dopées (20) dans ladite couche en polysilicum (14) en implantant, de manière sélective, une impureté (P) du type N dans ladite couche en polysilicum (14).

12. Procédé selon la revendication 11, comprenant l'étape de sélection de ladite impureté (P) du type N à partir du groupe constitué du phosphore et de l'arsenic.

13. Procédé selon la revendication 5 ou 6, dans lequel ladite étape de formation dudit motif de réseau de résistances souhaité comprend les étapes de formation de ladite couche en polysilicum (14) pour avoir des motifs de corps de résistance compris entre environ 2 à 4µm de long et environ 1µm de large.

14. Procédé selon la revendication 1 ou 6, dans lequel ladite étape de formation de ladite couche d'oxyde non dopé (25) sur la totalité est accomplie par un processus de réduction TEOS.

15. Procédé selon la revendication 6, dans lequel ladite étape de formation de ladite couche d'oxyde non dopé (25) sur la totalité est accomplie en formant une couche d'oxyde non dopé (25) d'une épaisseur comprise entre environ 1.200 Å à 1.500 Å.

16. Procédé selon la revendication 15, comprenant de plus l'encapsulation complète de ladite couche en polysilicum (14) avec ladite couche d'oxyde non dopé (25).

17. Procédé selon la revendication 1 ou 6, comprenant de plus l'étape consistant à permettre à ladite couche d'oxyde non dopé (25) de rester en permanence sur ladite couche en polysilicum (14).

18. Procédé selon la revendication 17, comprenant de plus l'étape consistant à permettre à ladite couche d'oxyde non dopé (25) de servir d'oxyde sous-BPSG.

19. Procédé selon la revendication 1 ou 6, dans lequel ladite étape d'implantation d'un agent de dopage (Bo) à travers ladite couche d'oxyde non dopé (25) comprend l'implantation d'ions de bore.

20. Procédé selon la revendication 19, dans lequel ladite étape d'implantation de bore comprend l'implantation de bore avec une énergie d'implantation comprise entre environ 40 keV et 60 keV.

21. Procédé selon la revendication 1 ou 6, dans lequel ladite étape d'implantation d'un agent de dopage (Bo) comprend l'implantation d'un agent de dopage sélectionné à partir du groupe constitué du bore, de l'antimoine, et de l'arsenic.
